# EUROPEAN PATENT SPECIFICATION

(11) **EP 2 685 242 B1**
(45) Date of publication and mention of the grant of the patent: **23.09.2015**
(21) Application number: 12755116.6
(22) Date of filing: 08.03.2012
(51) Int. Cl.: G01N 21/88, G01B 11/25

(54) **VISION TESTING DEVICE WITH ENHANCED IMAGE CLARITY**
SEHTESTVORRICHTUNG MIT VERBESSERTER BILDKLARHEIT
DISPOSITIF D'EXAMEN VISUEL AYANT UNE CLARTÉ D'IMAGE AMÉLIORÉE

(30) Priority: 10.03.2011 KR 20110021441
(43) Date of publication of application: 15.01.2014
(73) Proprietor: Mer Skilful Feat Co., Ltd, Gunpo-si, Gyeonggi-do 435-776 (KR)
(72) Inventor: PARK, Chan Wha, Gunpo-si Gyeonggi-do 435-776 (KR); OH, Sang Min, Gunpo-si Gyeonggi-do 435-776 (KR); KIM, Sung Hyun, Gunpo-si Gyeonggi-do 435-776 (KR); KOO, Ja Myoung, Gunpo-si Gyeonggi-do 435-776 (KR)
(74) Representative: Gille Hrabal
(86) International application number: PCT/KR2012/001708
(87) International publication number: WO 2012/121558

(56) References cited:
- JP-A- 2007 333 591
- KR-B1- 100 378 490
- KR-B1- 100 406 843
- KR-B1- 101 000 047
- US-A- 5 105 149
- US-A- 5 461 417
- US-A- 6 084 663
- US-A1- 2005 073 590
- US-A1- 2011 002 527

## Description

### Technical Field

The present invention relates to a vision testing device. More particularly, the present invention relates to a vision testing device with an enhanced image clarity capable of improving an uniformity of the light of a lighting part irradiated on a testing object by using a light diffusion part, inspecting a height by using a multigrid pattern, and increasing a clarity of an image by eliminating a half mirror arranged in the front of a camera for photographing the testing object.

### Background Art

In general, a surface mounting technology SMT of assembling a surface mounting components in a printed circuit board and the like includes a technology for miniaturization/integration of a surface mounting device SMD, a development of precision assembly equipments of exactly assembling these surface mount devices, and a technology of operating various assembly equipments.

Typically, a surface mounting line consists of a surface mounting apparatus and an equipment such as a vision testing device. The surface mounting apparatus is an equipment for mounting the surface mounting device on the printed circuit board. Various surface mounting devices, which are supplied in the form of tapes, sticks and trays, are supplied by feeders and it performs a task to put the surface mounting devices on a mounting position of the printed circuit board.

In addition, the vision testing device checks out the mounting status of the surface mounting device prior to or after the completion of the soldering process of the surface mounting device and the printed circuit board is transferred to the next process depending on the result of the process.

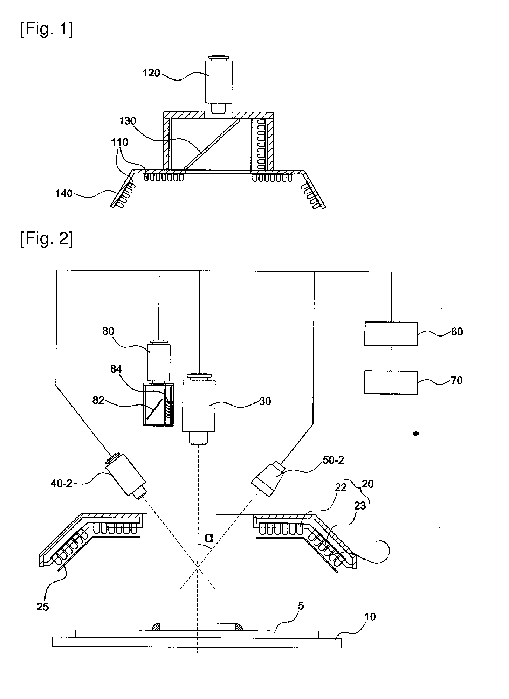

As shown in FIG. 1, a typical vision testing device includes a lighting part 110 for irradiating a light using a lamp etc., a camera part 120 for photographing image information of various parts mounted on the testing object installed on the upper part of the lighting part 110, and a half mirror 130 for reflecting the light from the lighting part, illuminating the light on the testing object, and transmitting the shape of the testing object to the camera part.

Here, the lighting part 110 having various lamps is located in the housing 140. When the lighting part irradiates the light on the testing object, the power is supplied to the plurality of the lamps, thereby irradiating the light thereon.

In the typical vision testing method, when the testing object is horizontally moved through a conveyor, the initial position is adjusted in a position adjusting device and then, the light is irradiated on LED parts or printed circuit boards through the grids. Thereafter, it analyzes the shadow shape formed and reflected on the surface of the testing object by means of the irradiated light, so that the height thereof is measured in three dimensions.

Then, the photographed portions are calculated and the calculated values are compared with the reference value, it can check good or bad of the mounting status of the parts related with the height and check whether the surface mounting parts are mounted or not.

In case of the above test methods, it measures two-dimensional shadow shape and then, the three-dimensional height is calculated through trigonometric functions.

Therefore, to clearly photography and classify the shadow pattern formed by the irradiated light is very important element in the vision testing device using the structured light.

On the other hand, in the conventional vision testing device, since the half mirror for reflecting the light and photographing the images is arranged on the front of the center camera part, it is an obstacle to the photographing of a clear image.

Also, since the light of the lighting part is directly irradiated on the surface of the testing object, the light is overlapped, so that the directly irradiated portion is relatively very bright, on the other hand, a portion having a low optical density is relatively dark.

Moreover, since the components such as a laser part and a camera part etc. for recognizing whether the testing object substrate is seated in the correct position or not are accommodated in the central camera part, the size and weight of the entire components accommodated in the housing for accommodating the central camera are increased, thereby causing inconvenience in terms of maintenance thereof.

US-5461417 describes a vision testing device with an enhanced image clarity.

### Disclosure

### Technical Problem

Accordingly, the present invention has been made to solve the above-mentioned problems occurring in the prior art, and an object of the present invention is to provide a vision testing device capable of improving an uniformity of the light irradiated on a surface of a testing object.

Another object of the present invention is to provide a vision testing device capable of photographing a clear image by eliminating a half mirror arranged in the front of a center camera part.

Further another object of the present invention is to provide a vision testing device capable of providing a convenient maintenance by miniaturizing the size of the device and dispersing the components thereof.

### Technical solution

In order to accomplish this object, there is provided a vision testing device according to claim 1.

Preferably, the grid pattern irradiating part comprises a LCD panel or a DMD (digital micromirror display).

According to the invention, the lighting part comprises a horizontal lighting part for irradiating the light in a vertical downward direction and a slope lighting part for irradiating the light in a slope direction.

According to the invention, the light diffusion part is arranged in the front of the horizontal lighting part and the slope lighting part.

Preferably, a third camera part for confirming the position of the testing object is formed at one side portion of the first camera part.

Here, a position confirmation lighting part and a half mirror are formed in the front of the third camera part.

Preferably, the angle between the grid pattern irradiating parts and the first camera part is 25 degrees through 45 degrees from the side section view thereof.

### Advantageous Effects

According to the present invention, it is possible to improve the uniformity of the light irradiated on a surface of a testing object.

Also, it is possible to photography the clear image by eliminating the half mirror arranged in the front of the center camera part.

Moreover, it is possible to provide the convenient maintenance by miniaturizing the size of the device and dispersing the components thereof.

### Brief Description of the Drawings

The above and other objects, features and advantages of the present invention will be more apparent from the following detailed description taken in conjunction with the accompanying drawings, in which:
FIG. 1 is a side sectional view of a conventional vision testing device;
FIG. 2 is a schematic side sectional view of a vision testing device according to the present invention; and
FIG. 3 is a schematic planar view of a vision testing device according to the present invention.

### Best Mode

### Mode for Invention

Hereinafter, an exemplary embodiment of the present invention will be described in detail with reference to the accompanying drawings.

Prior to this, the terms used in the present specification and claims are not limited to the terms used in the dictionary sense. On the basis of the principle that the inventor can define the appropriate concept of the term in order to describe his/her own invention in the best way, it should be interpreted as meaning and concepts for complying with the technical idea of the present invention.

Thus, though the preferred embodiments of the present invention with drawings have been disclosed for illustrative purposes, those skilled in the art will appreciate that various modifications, additions and substitutions are possible within the scope of the invention as defined by the appended claims.

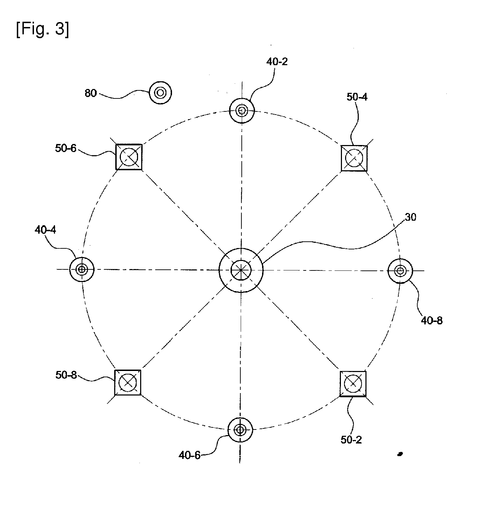

FIG. 2 is a schematic side sectional view of a vision testing device according to the present invention and FIG. 3 is a schematic planar view of a vision testing device according to the present invention.

Referring to FIG. 2 and FIG. 3, the vision testing device according to the present invention is a vision testing device with an enhanced image clarity for determining good or bad of a testing object by photographing the testing object assembled or mounted during the component assembly process and comparing the photographed image with a previously inputted target image, and includes a stage part 10 for fixing or transferring the testing object 5 to the testing location; a lighting part 20 for providing lighting to the testing object 5 located on an upper portion of the stage part 10; a first camera part 30 for obtaining a 2-dimensional image of the testing object located in a center of the lighting part 20; a plurality of second camera parts 40-2, 40-4, 40-6, and 40-8 placed on a side section of the first camera part 30; a plurality of grid pattern irradiating parts 50-2, 50-4, 50-6, and 50-8 placed between cameras of the second camera parts 40-2, 40-4, 40-6, and 40-8; a vision processing unit 60 for reading the image photographed by the first camera part 30 and the second camera parts 40-2, 40-4, 40-6, and 40-8 and determining good or bad of the testing object; and a control unit 70 for controlling the stage part 10, the light irradiating parts, and the first and second camera parts 30, 40-2, 40-4, 40-6, and 40-8; and a light diffusion part formed in the front of the lighting part 20.

When it inspects the surface mounting device of the printed circuit board in that the work is completed in the surface mounting line, the vision testing device according to the present invention is installed to be able to perform the vision test before moving to the next process through the conveyor of the previous equipment.

Such the vision testing device can be installed in any method to be placed in the space formed between conveyors of the proceeding and following equipments; or can also be used in a solo table form that is not associated with the previous and following equipments.

The stage part 10 is a component for providing a space that the testing object 5 is seated thereon. The stage part 10 can include a position control part (not shown) and a fixing part (not shown) for controlling and fixing the the position of the testing object 5.

The lighting part 20 is continuously or intermittently formed on the upper portion of the stage part 10 along the circumferential direction around the camera part 30.

The lighting part 20 is a component for providing the lighting to the testing object 5 so as to ensure the correct image information of the testing object 5. It can be configured to place a plurality of lamps or LED bulbs thereon so as to illuminate the testing object 5 from all sides.

The lighting part 20 includes a horizontal lighting part 22 and a slope lighting part 23.

Here, the horizontal lighting part 22 is located on the upper portion of the stage part 10 so as to provide a vertically incident light to the testing object 5.

The slope lighting part 23 is disposed on the side of the horizontal lighting part 22 so as to provide a light of a slope direction to the testing object 5.

The first camera part 30 is component for photographing the testing object 5. Preferably, it may be a CCD (charge coupled device).

The first camera part 30 serves to perform the two-dimensional scan test of the testing object 5 and to measure the height of the testing object by photographing a modified degree of the grid patterns irradiated by the grid pattern irradiating parts 50-2, 50-4, 50-6, and 50-8.

In case of the conventional vision testing device illustrated in FIG. 1, the half mirror is usually arranged on the front of the center camera part 120, so that it is possible to photograph the images through the camera 120 by reflecting the light from the lighting part 110. However, in the present invention, the half mirror is not arranged on the front of the first camera part 30.

Accordingly, it is possible to vividly photograph the image through the first camera part 30.

The plurality of the second camera parts 40-2, 40-4, 40-6, and 40-8 is formed at the side part of the first camera part 30 and placed symmetrically on the first camera part 30, so that it can eliminate blind spots of images and quickly photograph the images.

As shown in FIG. 3, four second camera parts 40-2, 40-4, 40-6, and 40-8 are placed symmetrically on the first camera part 30, so that it can inspect an abnormal position and non-inserting status of the parts arranged on the testing object such as the printed circuit board etc.

The grid pattern irradiating parts 50-2, 50-4, 50-6, and 50-8 are components for irradiate the grid patterns on the testing object 5 so as to measure the height thereof. The grid pattern irradiating parts 50-2, 50-4, 50-6, and 50-8 include a LCD panel or a DMD (digital micromirror display) and a light source.

Accordingly, a shadow of a grid shape is irradiated on the testing object 5 according to the control of the control unit 70 and the a modified degree of the shadow of the grid shape is photographed through the first camera part 30, so that it can calculate the height of the parts.

The grid pattern irradiating parts 50-2, 50-4, 50-6, and 50-8 are placed symmetrically on the first camera part 30, so that it can simultaneously or sequentially to irradiate the grid patterns on the testing object 5.

Here, the grid pattern irradiating parts 50-2, 50-4, 50-6, and 50-8 can irradiate the grid patterns having various colors such as a red or a blue etc. on the testing object 5.

Accordingly, the grid pattern having a larger interval and the grid pattern having a smaller interval are irradiated on the testing object 5 with different colors, so that it can reduce the time required to measure the height of the part and measure a more accurate height thereof.

It is preferred that the angle α between the grid pattern irradiating parts 50-2, 50-4, 50-6, and 50-8 and the first camera part 30 is 25 degrees through 45 degrees.

If the angle α is smaller than 25 degrees, since the modified degree of the grid patterns owing to the height of the parts is small, it can cause errors in the height calculation thereof. If the angle α is larger than 45 degrees, since the modified degree of the grid patterns owing to the height of the parts is small, since the difference of the width between grid patterns irradiated on the near and far sides of the grid pattern irradiating parts 50-2, 50-4, 50-6, and 50-8 is remarkably great, it can cause errors in the height calculation thereof.

When it is placed in the above angle range, the irradiated grid pattern is photographed through the first camera part 30, so that the grid pattern can be appropriately modified according to the height of the testing object.

On the other hand, the vision processing part 60 serves to compare the image information of the testing object 5 obtained from the first and second camera parts with a previously inputted image, so that it can determine good or bad of the testing object 5.

The control unit 70 is a component having a motion controller for controlling the driving and the operation of the stage part 10 and the first and second camera parts. The control unit 70 can be configured to control the entire driving of the vision testing device according to the present invention.

The control part 70 serves to control the photographing location of vision testing device, process the photographed images, and physically control the lighting part according to a system control program. Also, the control part 70 serves to perform the test operation and the data calculation operation.

Moreover, the control part 70 serves to perform the overall control of the vision testing device such as a control of an outputting device for outputting the working contents and the test results to a monitor and a control of an inputting device for inputting the setting items and the several items by means of the operator.

On the other hand, a light diffusion part 25 such as a light diffusion plate is formed in the front of the lighting part 20, so that the light of the lighting part 20 is evenly irradiated on the entire area of the testing object 5.

Accordingly, since the difference between the dark and light areas of the testing object can be decreased, it can photography the sharper images.

The light diffusion part 25 is constructed in the curved shape from the side section view thereof so as to be arranged in the front of the horizontal lighting part 22 and the slope lighting part 23.

In the meantime, a third camera part 80 for confirming the position of the testing object is formed at one side portion of the first camera part 30.

Here, a position confirmation lighting part 84 and a half mirror 82 are formed in the front of the third camera part 80.

Accordingly, in comparison with the conventional vision testing device of FIG. 1 in that the position of the testing object is confirmed through the center camera part 120, since the components for confirming the position thereof is accommodated in the housing of the separated third camera part 80, the housing diameter of the first camera part 30 can be reduced and the management thereof is easier in the case of a part failure.

Although the preferred embodiments of the present invention with drawings have been disclosed for illustrative purposes, those skilled in the art will appreciate that various modifications, additions and substitutions are possible, without departing from the scope of the invention as defined in the accompanying claims.

## Claims

1. A vision testing device with an enhanced image clarity for determining good or bad of a testing object by photographing a testing object assembled or mounted during the component assembly process and comparing the photographed image with a previously inputted target image, comprising:
a stage part (10) for fixing or transferring the testing object (5) to a testing location;
a lighting part (20) for providing lighting to the testing object located on an upper portion of the stage part;
a first camera part (30) for obtaining a 2-dimensional image of the testing object located in a center of the lighting part;
a plurality of second camera parts (40-2, 40-4, 40-6, 40-8) placed on a side section of the first camera part;
a vision processing unit (60) for reading the image photographed by the first camera part and the second camera parts and determining good or bad of the testing object;
a control unit (70) for controlling the stage part, the light irradiating parts, and the first and second camera parts; and
a light diffusion part (25) formed in the front of the lighting part ;
**characterized by** comprising
a plurality of grid pattern irradiating parts (50-2, 50-4, 50-6, 50-8) placed between cameras of the second camera parts (40-2, 40-4, 40-6, 40-8);
wherein the lighting part comprises a horizontal lighting part (22), which is located on the upper portion of the stage part, for irradiating the light in a vertical downward direction, and a slope lighting part (23), which is located on the side of the horizontal lighting part, for irradiating the light in a slope direction; and
the light diffusion part (25) is arranged in the front of the horizontal lighting part and the slope lighting part.

2. The vision testing device with an enhanced image clarity according to claim 1, wherein the grid pattern irradiating part comprises a LCD panel or a DMD (digital micromirror display).

3. The vision testing device with an enhanced image clarity according to claim 1, wherein a third camera part (80) for confirming the position of the testing object is formed at one side portion of the first camera part.

4. The vision testing device with an enhanced image clarity according to claim 3, wherein a position confirmation lighting part (84) and a half mirror (82) are formed in the front of the third camera part.

5. The vision testing device with an enhanced image clarity according to claim 1, wherein the angle between the grid pattern irradiating parts and the first camera part is 25 degrees through 45 degrees from the side section view thereof.

## Patentansprüche

1. Sichtprüfungsvorrichtung mit verbesserter Bildklarheit zum Bestimmen von gut oder schlecht eines Prüfgegenstands durch Fotografieren eines zusammengebauten oder montierten Prüfgegenstands während des Komponenten-Zusammenbauvorgangs und Vergleichen des fotografierten Bilds mit einem zuvor eingegebenen Zielbild, die folgendes aufweist:
ein Plattformelement (10) zum Befestigen oder Überführen des Prüfgegenstands (5) an einen Prüfort;
ein Beleuchtungselement (20) zum Bereitstellen von Beleuchtung für den auf einem oberen Element des Plattformelements angeordneten Prüfgegenstand;
ein erstes Kameraelement (30) zum Erhalten eines zweidimensionalen Bilds des in einem Zentrum des Beleuchtungselements angeordneten Prüfgegenstands;
eine Vielzahl von zweiten Kameraelementen (40-2, 40-4, 40-6, 40-8), die an einem seitlichen Abschnitt des ersten Kameraelements angeordnet sind;
eine Sichtverarbeitungseinheit (60) zum Einlesen des mit dem ersten Kameraelement und den zweiten Kameraelementen fotografierten Bilds und Bestimmen von gut oder schlecht des Prüfgegenstands;
eine Steuerungseinheit (70) zum Steuern des Plattformelements, der Lichtbestrahlungselemente und der ersten und zweiten Kameraelemente; und
ein Lichtdiffusionselement (25), das in der Front des Beleuchtungselements ausgebildet ist;
**dadurch gekennzeichnet, dass** es folgendes umfasst:
eine Vielzahl von Gittermuster-Beleuchtungselementen (50-2, 50-4, 50-6, 50-8), die zwischen den Kameras der zweiten Kameraelemente (40-2, 40-4, 40-6, 40-8) angeordnet sind;
wobei das Beleuchtungselement ein horizontales Beleuchtungselement (22) umfasst, das auf dem oberen Element des Plattformelements angeordnet ist, zum Einstrahlen des Lichts in einer vertikalen Richtung nach unten, und ein geneigtes Beleuchtungselement (23), das auf der Seite des horizontalen Beleuchtungselements angeordnet ist, zum Einstrahlen des Lichts in einer geneigten Richtung; und
das Lichtdiffusionselement (25) in der Front des horizontalen Beleuchtungselements und dem geneigten Beleuchtungselement angeordnet ist.

2. Sichtprüfungsvorrichtung mit verbesserter Bildklarheit nach Anspruch 1, wobei das Gittermuster-Beleuchtungselement eine LCD-Tafel oder einen DMD (Digital Micromirror Device) umfasst.

3. Sichtprüfungsvorrichtung mit verbesserter Bildklarheit nach Anspruch 1, wobei ein drittes Beleuchtungselement (80) zum Bestätigen der Position des Prüfgegenstands an einem seitlichen Abschnitt des ersten Kameraelements ausgebildet ist.

4. Sichtprüfungsvorrichtung mit verbesserter Bildklarheit nach Anspruch 3, wobei ein Positionsbestätigungsbeleuchtungselement (84) und ein Halbspiegel (82) in der Front des dritten Beleuchtungselements ausgebildet sind.

5. Sichtprüfungsvorrichtung mit verbesserter Bildklarheit nach Anspruch 1, wobei der Winkel zwischen den Gittermuster-Beleuchtungselementen und dem ersten Kameraelemente 25° bis 45°, betrachtet vom seitlichen Abschnitt davon, beträgt.

## Revendications

1. Dispositif de contrôle visuel ayant une clarté d'image améliorée pour déterminer le bien ou le mal d'un l'objet d'essai en photographiant un objet d'essai assemblé ou monté pendant le procédé d'assemblage de composants et comparant l'image photographié avec un image de cible saisie auparavant, comprenant :
une pièce de platine (10) pour fixer ou transférer l'objet d'essai (5) à un endroit de contrôle ;
une pièce d'éclairage (20) pour fournir l'éclairage à l'objet d'essai localisé sur une partie supérieure de la pièce de platine ;
une première pièce de caméra (30) pour obtenir une image bidimensionnelle de l'objet d'essai localisé dans un centre de la pièce d'éclairage ;
une pluralité de secondes pièces de camera (40-2, 40-4, 40-6, 40-8) placées sur une section de côté de la première pièce de camera ;
une unité processeur de vision (60) pour lire l'image photographiée par la première pièce de caméra et les secondes pièces de camera et déterminer le bon ou le mal de l'objet d'essai ;
une unité de contrôle (70) pour contrôler la pièce de platine, les pièces d'irradiation par lumière, et les premières et secondes pièces de camera ; et
une pièce de diffusion de la lumière (25) agencée dans la face avant de la pièce d'éclairage ;
**caractérisé en ce qu'**il comprend
une pluralité de pièces d'éclairage à motif de grille (50-2, 50-4, 50-6, 50-8) placées entre les cameras des secondes pièces de camera (40-2, 40-4, 40-6, 40-8) ;
dans lequel la pièce d'éclairage comprend une pièce d'éclairage horizontale (22), qui est localisée sur la partie supérieure de la pièce de platine, pour irradier la lumière dans une direction verticale vers le bas, et une pièce d'éclairage inclinée (23), qui est localisée sur le côté de la pièce d'éclairage horizontale, pour irradier la lumière dans une direction inclinée ;
et
la pièce de diffusion de la lumière (25) est arrangée dans la face avant de la pièce d'éclairage horizontale et la pièce d'éclairage inclinée.

2. Dispositif de contrôle visuel ayant une clarté d'image améliorée selon la revendication 1, dans lequel la pièce d'éclairage à motif de grille comprend un panneau LCD ou un DMD (Digital Micromirror Device).

3. Dispositif de contrôle visuel ayant une clarté d'image améliorée selon la revendication 1, dans lequel une troisième pièce d'éclairage (80) pour confirmer la position de l'objet d'essai est agencée à une partie de côté de la première pièce de camera.

4. Dispositif de contrôle visuel ayant une clarté d'image améliorée selon la revendication 3, dans lequel une pièce d'éclairage de confirmation de position (84) et un demi-miroir (82) sont agencés dans la face avant de la troisième pièce de camera.

5. Dispositif de contrôle visuel ayant une clarté d'image améliorée selon la revendication 1, dans lequel l'angle entre les parties d'éclairage à motif de grille et la première pièce de camera est 25° jusqu'à 45° en le regardant à partir de la section de côté de celui-ci.
